Europäisches Patentamt

European Patent Office

Office européen des brevets

(19)

(11) Numéro de publication : **0 334 763 B1**

(12) **FASCICULE DE BREVET EUROPEEN**

(45) Date de publication du fascicule du brevet :
**10.06.92 Bulletin 92/24**

(51) Int. Cl.$^5$ : **G11C 29/00**

(21) Numéro de dépôt : **89400826.7**

(22) Date de dépôt : **23.03.89**

(54) **Procédé de test de mémoire à programmation unique et mémoire correspondante.**

(30) Priorité : **25.03.88 FR 8803918**

(43) Date de publication de la demande :
**27.09.89 Bulletin 89/39**

(45) Mention de la délivrance du brevet :
**10.06.92 Bulletin 92/24**

(84) Etats contractants désignés :
**DE ES GB IT NL**

(56) Documents cités :
**EP-A- 0 012 018**
**EP-A- 0 206 844**

(73) Titulaire : **SGS-THOMSON**
**MICROELECTRONICS S.A.**
**7, Avenue Galliéni**
**F-94250 Gentilly (FR)**

(72) Inventeur : **Gaultier, Jean-Marie**
**Cabinet Ballot-Schmit 84, Avenue Kléber**
**F-75116 Paris (FR)**
Inventeur : **Farrugia, Augustin**
**Cabinet Ballot-Schmit 84, Avenue Kléber**
**F-75116 Paris (FR)**
Inventeur : **Conan, Bertrand**
**Cabinet Ballot-Schmit 84, Avenue Kléber**
**F-75116 Paris (FR)**

(74) Mandataire : **Ballot, Paul Denis Jacques et al**
**Cabinet Ballot-Schmit, 7, rue le Sueur**
**F-75116 Paris (FR)**

**Description**

L'invention concerne les mémoires programmables une seule fois, connues sous le nom de mémoires OTP, abbréviation de l'anglais "One Time Programmable".

Ces mémoires sont des mémoires EPROM, c'est-à-dire des mémoires non-volatiles programmables électriquement; mais, contrairement aux mémoires EPROM classiques qui sont pourvues d'une fenêtre transparente aux ultra-violets et qui peuvent, grâce à cette fenêtre, être effacées par ultraviolets puis reprogrammées électriquement, les mémoires OTP sont encapsulées dans un boîtier opaque, non transparent aux ultraviolets. Une fois qu'elles sont programmées elles ne peuvent plus être effacées.

Plus précisément, chaque bit de la mémoire est initialement dans un état non programmé; si on le programme, cela veut dire qu'on change son état, et on ne peut plus revenir en arrière au premier état.

Le plus fréquemment, chaque point de mémoire est constitué par un transistor ayant une grille de commande et une grille flottante; par une polarisation adéquate de la source, du drain et de la grille de commande, on peut programmer ce transistor, ce qui signifie qu'on charge de manière permanente sa grille flottante. Si le transistor est dans son état initial "non programmé", il peut facilement être rendu conducteur par une tension de lecture appliquée à sa grille de commande; s'il est dans l'état "programmé" (sa grille flottante est remplie d'électrons), il ne peut plus être rendu conducteur par la même tension de lecture appliquée à sa grille de commande.

On comprendra facilement qu'il est très difficile de tester des mémoires de ce type, en tout cas après qu'elles aient été encapsulées dans leur boîtier opaque définitif. En effet, on ne peut pas les programmer pour les tester; il faut les vendre vierges d'informations, c'est-à-dire qu'on ne peut les vendre que non programmées, l'acheteur effectuant la programmation pour y mettre l'information qu'il désire. S'il n'y a pas d'information dans la mémoire, il est évidemment impossible d'effectuer certains tests sur l'exactitude des informations stockées ou sur la qualité des chemins d'accès à ces informations; pourtant l'acheteur souhaite des garanties sur le produit qu'il va acheter et il serait souhaitable d'effectuer certains tests.

Par exemple, un test qu'il est intéressant d'effectuer est un test de vitesse, par lequel on vérifie le délai qui s'écoule entre le moment où on désigne une adresse de la mémoire et le moment où on reçoit en sortie l'information stockée à cette adresse.

Ce test devient très imprécis si on l'effectue sur une mémoire dont tous les transistors sont dans l'état non programmé. En effet, on va essayer d'adresser successivement à des intervalles de temps très brefs des points mémoires différents et regarder au bout de combien de temps l'information est reçue à la sortie;

mais comme l'information sera toujours la même quel que soit le point adressé, on ne distinguera pas vraiment où est la fin de l'information précédente et le début de l'information suivante.

C'est d'ailleurs pourquoi, dans les mémoires non OTP, on fait des tests de vitesse en inscrivant dans la mémoire une information en "damier", c'est-à-dire qu'on programme un transistor sur deux et on lit à grande vitesse les adresses successives de la mémoire : l'information en sortie sera alternativement un "zéro" et un "un" logiques et il sera facile de vérifier la vitesse maximale d'accès aux points-mémoire.

Cette vitesse d'accès est notamment limitée par les circuits de décodage de ligne et de colonne de la mémoire, les amplificateurs d'entrée et de sortie, etc.

La présente invention propose un moyen pour faciliter le test des mémoires programmables une seule fois, notamment le test de vitesse mais aussi le test des défauts des circuits de décodage et de certaines parties du réseau de points de la mémoire.

Selon l'invention, puisqu'on ne peut pas programmer les points-mémoire pour vérifier le comportement de la mémoire contenant des points programmés et des points non programmés, on propose de simuler des points-mémoires programmés par des points-mémoires non programmés dont on aura inhibé l'adressage en lecture pour faire croire qu'ils sont programmés. Pour exprimer ce concept autrement, on peut dire la chose suivante : si on désigne un point-mémoire particulier au moyen d'une tension de lecture appliquée par un décodeur à ce point-mémoire et qu'on lit sur un conducteur de colonne l'état du point-mémoire, il y a deux possibilités : ou bien le point-mémoire n'est pas programmé et le transistor qui le constitue fournira un courant montrant qu'effectivement il n'est pas programmé, ou bien le point-mémoire est programmé et alors il ne peut plus être rendu conducteur par la tension de lecture appliquée par le décodeur, et dans ce cas aucun courant ne circule et n'est détecté sur le conducteur de colonne. Mais alors, si aucun courant n'est détecté, le conducteur de colonne se comporte exactement comme si le point-mémoire n'était pas du tout adressé; il se comporte comme s'il ne recevait pas la tension de lecture issue du décodeur, ou comme s'il n'était pas relié à la sortie de la mémoire.

L'idée de l'invention consiste donc
– à appliquer à un décodeur des adresses successives de points-mémoire à tester;
– à faire appliquer par le décodeur une tension de lecture à ces points pour qu'ils fournissent en sortie de la mémoire une information sur leur état;
– à inhiber la lecture lorsque certains points-mémoire sont désignés par le décodeur pour que ces points se comportent, vus de la sortie, comme des points qui sont dans un état différent de l'état dans lequel ils sont en réalité; pendant cette inhibition, le décodeur n'adresse pas d'éléments mémoires supplémentaires qui seraient réservés au test.

L'inhibition de la lecture peut consister à empêcher l'application d'une tension de lecture aux points mémoire désignés, ou encore à empêcher la transmission à la sortie de la mémoire de l'information lue sur la colonne.

Ainsi, tous les points qu'on désignera par des signaux d'adressage inhibés pourront être considérés comme des points programmés de la mémoire alors qu'ils ne le sont pas en réalité.

On simule ainsi le contenu désiré d'une mémoire dont en fait tous les points sont dans le même état non programmé, et on regarde le comportement de la mémoire dont le contenu est ainsi simulé.

Par exemple, on simulera un contenu en damier d'une mémoire en inhibant la transmission des signaux d'adresse aux points-mémoire pour un point sur deux et en l'autorisant pour le point suivant. On pourrait aussi simuler d'autres motifs qu'un damier, le motif le plus simple étant un motif de lignes alternées de points programmés et de points non programmés; des motifs plus complexes peuvent être envisagés sans difficulté de principe mais ils nécessiteraient dans le circuit-intégré de mémoire des circuits de décodage spécifiques supplémentaires d'autant plus encombrants que le motif est plus complexe et on évitera donc d'en abuser.

C'est en effet le circuit-intégré comportant la mémoire qui comprendra des circuits auxiliaires spécifiques permettant cette simulation de contenu de mémoire lors du test.

La mémoire selon l'invention exposée dans la revendication 1 comporte un réseau de points-mémoire ayant un état vierge et un état programmé et dont l'état peut être lu sélectivement à partir d'au moins un décodeur apte à recevoir une adresse de sélection d'un point-mémoire et apte à transmettre à un point-mémoire sélectionné une tension de lecture, la mémoire comportant une borne de mode de test destinée à recevoir un signal indiquant si la mémoire doit fonctionner normalement ou être testée; elle est caractérisée en ce qu'elle comporte un circuit spécifique contrôlé par la borne de mode de test pour autoriser, en mode de test, l'inhibition de la lecture de certains des points-mémoire lorsque l'adresse de ces points est reçue par le décodeur, de manière que, vus de la sortie de la mémoire, ces points-mémoire fournissent une information intentionnellement erronée sur leur état vierge.

C'est ce qui permet de simuler des points programmés alors qu'ils ne le sont pas en réalité. Et il n'y a pas de ligne ou colonne supplémentaire d'éléments mémoire réservés au test.

En mode de fonctionnement normal ce circuit spécifique est évidemment inhibé.

Dans l'exemple simple mais particulièrement utile où le contenu simulé est un contenu en damier, le circuit spécifique comprend des interrupteurs commandés en fonction de l'état des bits de poids faible des adresses de ligne et de colonne de la mémoire; ces interrupteurs permettent de court-circuiter le conducteur de ligne d'une ligne sélectionnée, ou de désélectionner un conducteur de colonne lorsque l'adresse de ligne correspond à une ligne de rang impair (par exemple) et que simultanément l'adresse de colonne reçue correspond aussi à une colonne de rang impair (par exemple).

Plus généralement, le circuit spécifique peut être un circuit logique apte à inhiber l'application d'une tension de lecture sur une ligne sélectionnée, en fonction de l'état d'un bit d'adresse de cette ligne.

Il peut être aussi un circuit logique apte à inhiber l'application d'une tension de lecture sur une ligne sélectionnée, en fonction de l'état d'un bit d'adresse d'une colonne sélectionnée en même temps que la ligne, l'adresse de ligne et l'adresse de colonne définissant la position d'un point-mémoire dont on veut masquer l'état.

Dans le cas où le contenu de mémoire qu'on veut simuler est un damier, la mémoire comporte un circuit logique apte à inhiber la lecture pour une ligne sélectionnée en fonction de la valeur de la somme d'un bit d'adresse de cette ligne et d'un bit d'adresse d'une colonne sélectionnée en même temps que la ligne, l'adresse de ligne et l'adresse de colonne définissant la position d'un point mémoire dont on veut masquer l'état. Les bits choisis seront en principe les bits de poids faible en ligne et en colonne.

L'invention est intéressante spécialement pour les mémoires programmables une seule fois (EPROM encapsulées en boîtier plastique), mais elle pourrait s'appliquer à d'autres types de mémoire.

D'autres caractéristiques et avantages de l'invention apparaîtront à la lecture de la description détaillée qui suit et qui est faite en référence aux dessins annexés dans lesquels :

– la figure 1 représente schématiquement une mémoire EPROM classique;

– la figure 2 représente une modification de la mémoire permettant de mettre en application l'invention.

Pour mieux faire comprendre l'invention, on va montrer comment on peut la mettre en oeuvre dans le cas où on veut simuler un contenu en damier d'une mémoire adressable point par point au moyen d'un décodeur de ligne et d'un décodeur de colonne.

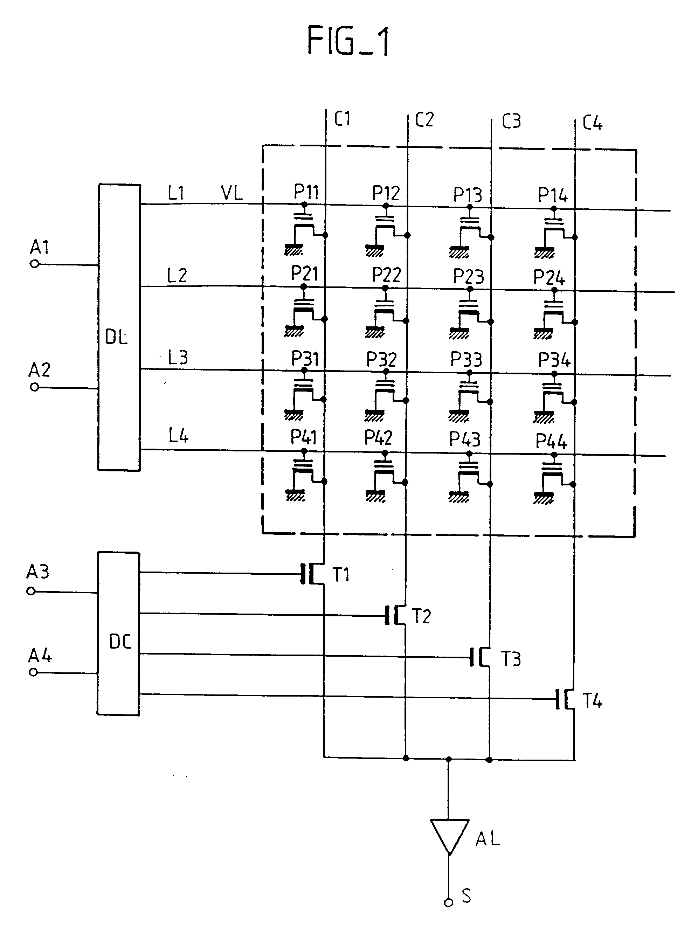

Une telle mémoire est représentée dans sa forme classique à la figure 1. On a représenté un cas très simple d'une mémoire de 16 points agencés en un réseau de quatre lignes et quatre colonnes avec un point mémoire au croisement de chaque ligne et chaque colonne.

Les quatre lignes sont matérialisées par quatre conducteurs parallèles L1, L2, L3, L4 et les quatre colonnes par quatre conducteurs C1, C2, C3, C4, perpendiculaires aux premiers.

Chaque point mémoire est désigné par la référence Pij, où i représente le numéro de la ligne à laquelle il appartient et j le numéro de la colonne. Ainsi, le point P11 est le point au carrefour de la ligne L1 et de la colonne C1, le point P12 est celui qui est au carrefour de la ligne L1 et de la colonne C2, et ainsi de suite jusqu'au point P44 au carrefour de la ligne L4 et de la colonne C4.

Chaque point-mémoire est constitué dans cet exemple par un transistor à grille flottante, ayant un source, un drain, une grille flottante et une grille de commande. La source est reliée à une masse électrique commune à tout le circuit, le drain est relié à la colonne auquel le point mémoire appartient, et la grille de commande est reliée à la ligne auquel le point-mémoire appartient.

Chaque point mémoire peut être désigné individuellement, pour y lire une information ou pour y écrire une information, grâce à un décodeur de ligne DL et à un décodeur de colonne DC.

Le décodeur de ligne DL a autant de sorties qu'il y a de lignes dans le réseau de mémoire; il sélectionne une ligne particulière et lui applique une tension de lecture VL permettant de rendre conducteurs les transistors non programmés mais ne permettant pas de rendre conducteurs les transistors programmés. Les lignes non sélectionnées ne reçoivent pas cette tension VL; elles sont par exemple maintenues au potentiel de la masse.

Le décodeur de colonne a autant de sorties qu'il y a de colonnes dans le réseau de mémoire; il sélectionne une colonne particulière pour la relier à un amplificateur de lecture AL; les colonnes non sélectionnées ne sont pas reliées à cet amplificateur de lecture. Dans l'exemple représenté, le décodeur de colonne a quatre sorties commandant chacune un transistor respectif (T1 à T4) en série entre un conducteur de colonne respectif et l'amplificateur de lecture. Le transistor T1 est commandé par la première sortie du décodeur de colonne et est en série avec le premier conducteur de colonne C1; le transistor T2 est commandé par la deuxième sortie du décodeur et est en série avec le deuxième conducteur de colonne C2, etc.

Le décodeur de ligne et le décodeur de colonne sont commandés par des signaux d'adresse. De manière extrêmement classique, il y a dans le plan mémoire un nombre de lignes qui est une puissance de deux ($2^n$) et un nombre de colonnes qui est aussi une puissance de deux ($2^p$). Il suffit alors de n entrées pour le décodeur de ligne et p entrées pour le décodeur de colonne pour définir un numéro de ligne entre 1 et $2^n$ et un numéro de colonne entre 1 et $2^p$, chaque entrée recevant un signal binaire de niveau logique 0 ou 1. L'adresse de ligne est définie par les signaux binaires sur les entrées du décodeur de ligne et l'adresse de colonne par les signaux binaires sur les entrées du décodeur de colonne.

Les lignes et les colonnes sont généralement agencées de telle sorte que deux adresses quine diffèrent que par leur bit de poids le plus faible correspondent à la sélection de deux lignes ou colonnes adjacentes; c'est en tout cas ce que l'on supposera dans l'exemple particulier décrit ici.

Dans cet exemple, il y a deux entrées d'adresse de ligne A1 et A2, et on supposera que l'entrée A2 correspond au poids le plus faible, c'est-à-dire que quel que soit le signal logique sur A1, une ligne de rang impair (L1 ou L3) sera sélectionnée pour un premier niveau logique (par exemple zéro) sur l'entrée A2, et au contraire une ligne de rang pair (L2 ou L4) sera sélectionnée pour le niveau logique complémentaire (niveau 1) sur l'entrée A2.

De même, il y a deux entrées d'adresse de colonne A3 et A4; A4 correspond au poids le plus faible et permet de choisir l'une de deux colonnes adjacentes dans un groupe de colonnes défini par A3. Les colonnes de rang impair par exemple sont désignées par un niveau logique 0 sur l'entrée A4.

En imposant une adresse de ligne et une adresse de colonne on définit une ligne et une colonne, donc un point-mémoire au croisement de cette ligne et de cette colonne et on détecte par l'amplificateur AL le courant qui circule dans la colonne sélectionnée; ce courant est non nul si le point-mémoire n'a pas été programmé et il est nul si le point mémoire a été programmé. L'information binaire sur l'état de chaque point-mémoire est fournie sur la sortie S de l'amplificateur de lecture AL.

Lorsqu'on veut tester la mémoire alors qu'elle est vierge (aucun point-mémoire programmé), on doit lire du courant systématiquement en sortie quel que soit l'adresse de ligne et de colonne appliquée aux entrées A1 à A4. Cela ne permet pas de tester correctement les circuits d'accès à la mémoire et en particulier la vitesse de ces circuits.

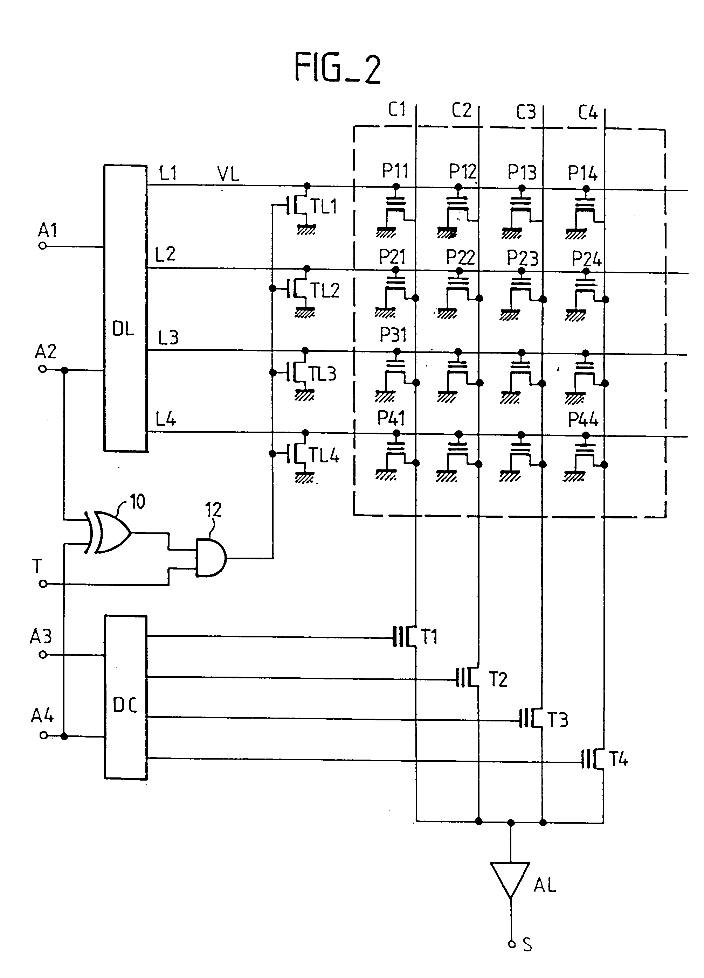

La modification apportée par l'invention à la mémoire pour faciliter le test est représentée à titre d'exemple à la figure 2; cette figure correspond à un exemple simple dans lequel on veut tester la réponse que présenteraient les circuits d'accès à la mémoire si le contenu était un damier de points programmés alternant avec des points non programmés; ce test est particulièrement intéressant parce qu'il représente des conditions sévères d'utilisation étant donné qu'il oblige la sortie S de la mémoire à fournir très rapidement des signaux successifs qui changent d'état à chaque changement d'adresse (en supposant bien sûr que les adresses successives sont appliquées dans l'ordre des positions successives de points en ligne ou en colonne).

Selon l'invention, pour certaines adresses reçues sur l'un ou l'autre des décodeurs, on va empêcher l'accès au plan-mémoire de sorte qu'on ne pourra pas lire le courant qui serait fourni par un transistor sélectionné par l'une de ces adresses. Cet accès n'est empêché bien sûr qu'en mode de test de la mémoire.

Pour toutes les adresses pour lesquelles l'accès est autorisé on lira un courant de sortie provenant d'un transistor non programmé rendu conducteur par une tension de lecture VL sur sa grille de commande (mais des défauts pourront être détectés éventuellement comme on le faisait auparavant).

Pour toutes les adresses pour lesquelles l'accès est inhibé on ne lira pas de courant en sorte (mais si on en lit quand même on pourra identifier des défauts).

En alternant l'application d'adresses avec accès autorisé et d'adresses avec accès non autorisé, on pourra tester le comportement en vitesse des circuits d'accès (décodeur de ligne, décodeur de colonne, amplificateur de lecture, etc.)

L'exemple représenté à la figure 2 est très simple; il comprend des transistors (TL1, TL2, TL3, TL4) pour empêcher, en mode de test, l'accès entre le décodeur de ligne et certaines lignes de la mémoire. Ces transistors permettent de relier à la masse ces lignes, de sorte que lorsqu'une tension de lecture VL est appliquée par le décodeur à une de ces lignes, cette tension est court-circuitée et ne peut pas être transmise aux grilles de commande des transistors de cette ligne.

Mais on pourrait prévoir en variante de réalisation que les transistors TL1 à TL4 sont connectés pour inhiber la transmission de courant entre les conducteurs de colonne et la sortie de la mémoire: les transistors TL1 à TL4 pourraient être connectés entre les grilles des transistors T1 à T4 et la masse de sorte qu'ils serviraient à empêcher toute mise en conduction des transistors T1 à T4, donc toute transmission de courant à l'amplificateur de lecture AL et par suite toute transmission d'information entre les conducteurs de colonne et la sortie S. Cette variante de réalisation présente notamment un intérêt lorsque l'amplificateur de lecture fonctionne en différentiel, avec une entrée de référence constituée par une colonne de cellules de référence adressées par le décodeur de ligne DEL. il ne faut pas alors court-circuiter les conducteurs de ligne pendant le test.

Outre les transistors TL1 à TL4, le circuit d'inhibition de l'accès à certaines lignes comprend des moyens de commande de ces transistors; ces moyens comprennent tout simplement des portes logiques recevant d'une part un signal logique issu d'une borne T de mode de test, et d'autre part (dans cet exemple) les bits d'adresse de poids faible présents sur la borne A2 d'une part (poids faible d'adresse de ligne) et sur la borne A4 d'autre part (poids faible d'adresse en colonne).

La borne de mode de test T fournit un signal logique qu'elle reçoit de l'extérieur du circuit et qui indique qu'on est en mode de fonctionnement normal ou en mode de test.

L'inhibition de l'accès à une ligne a lieu par mise à la masse de cette ligne lorsque l'adresse de cette ligne est fournie au décodeur de ligne, à condition qu'on soit en mode de test; mais dans l'exemple représenté l'inhibition est plus générale pour permettre facilement la simulation d'un damier avec des moyens logiques très limités; en effet, ici, on mettra à la masse toutes les lignes en même temps dès lors que l'adresse du point-mémoire désigné par les décodeurs de ligne et de colonne correspond à une adresse qu'on veut inhiber, c'est-à-dire dès lors que le point-mémoire choisi doit être considéré fictivement comme un point mémoire programmé.

Si les transistors TL1 à TL4 servaient à désélectionner les colonnes plutôt que les lignes, on prévoirait également de préférence que toutes les colonnes à la fois sont désélectionnées lorsqu'une adresse de point à inhiber est transmise.

Le circuit logique qui sert à simuler un contenu en damier peut comprendre comme on le voit sur la figure 2 une porte OU-Exclusif 10 dont une première entrée reçoit le bit de poids faible d'adresse de ligne (présent sur l'entrée A2) et dont une deuxième entrée reçoit le bit de poids faible d'adresse de colonne (présent sur l'entrée A4).

La sortie de la porte OU-Exclusif 10 fournit un premier niveau logique (0 par exemple) si la parité de l'adresse de ligne est la même que la parité de l'adresse de colonne, c'est-à-dire si on sélectionne un point soit au carrefour d'une ligne de rang impair et une colonne de rang impair soit au carrefour d'une ligne de rang pair et une colonne de rang pair; la sortie de la porte OU-Exclusif fournit un deuxième niveau logique complémentaire du premier si les parités de rang de ligne et de colonne sont différentes.

La sortie de la porte OU-Exclusif 10 est appliquée à une entrée d'une porte logique 12 (porte ET par exemple) validée par le signal de mode de test de la borne T, de sorte que ce n'est qu'en mode de test que l'accès aux conducteurs de ligne peut être inhibé.

La sortie de la porte 12 commande les transistors TL1 à TL4 pour les rendre conducteurs et interdire l'accès à la ligne sélectionnée ainsi d'ailleurs qu'à toutes les autres lignes dans le cas par exemple où les parités des adresses de ligne et de colonne sont différentes.

Il en résulte le fonctionnement suivant :

I. Mode normal

Si on est en mode de fonctionnement normal (par opposition au mode de test), la porte 12 ne laisse pas passer les signaux de sortie de la porte OU-Exclusif 10 et aucun des transistors d'inhibition TL1 à TL4 ne peut être rendu conducteur;

## II. Mode de test

a) si la ligne adressée a une parité de rang impair (ligne L1 ou L3), alors l'adressage de cette ligne sera inhibé par mise à la masse de cette ligne (et d'ailleurs de toutes les autres lignes) à condition que l'adresse de colonne fournie en même temps au décodeur de colonne corresponde aussi à une colonne de rang impair (C1 ou C3); si l'adresse de colonne est de rang pair (désignation des colonnes C2 ou C4), alors la ligne sélectionnée ne sera pas inhibée;

b) si la ligne adressée a une parité de rang pair (sélection de L2 ou L4), c'est la même chose: l'adressage de la ligne sera inhibé si la parité de l'adresse de colonne est également paire.

c) au total, un point sur deux sera normalement adressé; ses voisins immédiats en ligne et en colonne ne seront pas adressés lorsque les décodeurs de ligne et de colonne recevront les adresses qui devraient les sélectionner; ils ne fourniront pas de courant sur la colonne désignée et ils se comporteront donc, vus de la sortie S, comme des points mémoire programmés incapables d'être rendus conducteurs par la tension de lecture VL. On a donc bien simulé un damier de points-mémoire programmés alternant avec des points-mémoire non-programmés.

Il n'y a aucune difficulté à simuler d'autres motifs simples de contenu de mémoire, par exemple une alternance de lignes de points programmés et de points non programmés : la porte ET 12 aurait tout simplement une entrée connectée à la borne T et une autre connectée à l'entrée A2, la porte OU-Exclusif étant supprimée. De même pour simuler une alternance de colonnes de points programmés et de colonnes de points non-programmés, il suffirait de connecter une entrée de la porte ET 12 à l'entrée A4 en supprimant la porte OU-Exclusif.

D'autres motifs de contenu de mémoire peuvent être simulés à l'aide de circuits de décodage recevant certains bits d'adresse en ligne et en colonne pour commander les transistors TL1 à TL4 en fonction des adresses reçues à l'entrée des décodeurs.

L'invention permet de détecter des défauts de comportement du circuit-intégré et d'effectuer le tri en vitesse des mémoires mortes programmables une seule fois, même après encapsulation en boîtier opaque.

## Revendications

1. Mémoire morte comportant un réseau de points-mémoire (Pij) ayant un état vierge et un état programmé et dont l'état peut être lu sélectivement à partir d'au moins un décodeur (DL, DC) apte à recevoir une adresse de sélection d'un point-mémoire et apte à transmettre à un point-mémoire sélectionné une tension de lecture (VL), la mémoire comportant une borne de mode de test (T) destinée à recevoir un signal indiquant si la mémoire doit fonctionner normalement ou être testée, caractérisée en ce qu'elle comporte un circuit (10, 12) contrôlé par la borne de mode de test pour autoriser, en mode de test, l'inhibition de la lecture de certains des points-mémoire lorsque l'adresse de ces points est reçue par le décodeur, de manière que, vus de la sortie de la mémoire, ces points-mémoire fournissent une information intentionnellement erronée sur leur état vierge, et ceci sans sélectionner par ailleurs à l'aide du décodeur des lignes ou colonnes supplémentaires de points-mémoire réservés au test.

2. Mémoire selon la revendication 1, caractérisée en ce que les points-mémoire peuvent prendre deux états, et en ce que l'information en sortie de la mémoire est de deux types, en fonction de l'état du point mémoire :

– dans un premier état, le point-mémoire adressé fournit un signal électrique spécifique;

– dans un deuxième état le point-mémoire adressé ne fournit pas de signal spécifique différent des signaux issus de points-mémoire non adressés.

3. Mémoire selon la revendication 1, caractérisée en ce que les points-mémoire sont des transistors à grille flottante ou des éléments analogues pouvant être rendus conducteurs par une tension de lecture lorsqu'ils ne sont pas programmés dans leur deuxième état, et ne pouvant plus être rendus conducteurs par cette tension lorsqu'ils sont programmés dans leur deuxième état.

4. Mémoire selon l'une des revendications précédentes, caractérisée en ce qu'elle comporte un circuit logique (10, 12, TL1 à TL4) apte à inhiber l'application d'une tension de lecture sur une ligne sélectionnée.

5. Mémoire selon l'une des revendications précédentes, caractérisée en ce qu'elle comporte un circuit logique apte à inhiber la transmission d'information entre un conducteur de colonne et la sortie de la mémoire.

6. Mémoire selon l'une des revendications précédentes, caractérisée en ce que l'inhibition de la lecture est fonction de l'état d'un bit d'adresse (A2) d'une ligne.

7. Mémoire selon l'une des revendications précédentes, caractérisée en ce que l'inhibition de la lecture est fonction de l'état d'un bit d'adresse (A4) d'une colonne sélectionnée.

8. Mémoire selon l'une des revendications précédentes, caractérisée en ce qu'elle comporte un circuit logique (10, 12, TL1 à TL4) apte à inhiber la lecture en fonction de la valeur de la somme d'un bit d'adresse de ligne et d'un bit d'adresse de colonne sélectionnée en même temps que la ligne, l'adresse de ligne et l'adresse de colonne définissant la position d'un point mémoire dont on veut masquer l'état.

9. Mémoire selon l'une des revendications 6 à 8, dans laquelle le bit de poids faible de l'adresse de ligne permet de sélectionner l'une de deux lignes adjacentes et le bit de poids faible de l'adresse de colonne permet de sélectionner l'une de deux colonnes adjacentes, caractérisée en ce qu'elle comporte une porte logique (10) recevant le bit de poids faible de l'adresse de ligne et le bit de poids faible de l'adresse en colonne, et des interrupteurs (TL1 à TL4) aptes à inhiber la lecture lorsque, en mode de test, la somme des bits de poids faible en ligne et en colonne a une valeur spécifiée.

10. Mémoire selon la revendication 4, caractérisée en ce que le circuit d'inhibition de l'application de la tension de lecture inhibe non seulement l'application de la tension de lecture à la ligne sélectionnée mais aussi simultanément l'application de la tension de lecture à toutes les autres lignes, lorsque l'adresse fournie au décodeur correspond à la position d'un point-mémoire dont on veut masquer l'état.

11. Mémoire selon la revendication 5, caractérisée en ce que le circuit d'inhibition de transmission d'information de colonne inhibe non seulement la transmission pour une colonne sélectionnée mais aussi simultanément pour toutes les colonnes lorsque l'adresse fournie au décodeur correspond à la position d'un point-mémoire dont on veut masquer l'état.

12. Mémoire selon l'une des revendications 1 à 11, caractérisée en ce qu'elle est du type programmable une seule fois et en ce que l'état des points-mémoire au moment du test est le même pour tous les points.

13. Procédé de test d'une mémoire morte comprenant des points-mémoire qui peuvent prendre un premier ou un deuxième état, consistant
    – à appliquer à un décodeur (DL, DC) des adresses successives de points-mémoire à tester;
    – à faire appliquer par le décodeur une tension de lecture (VL) à ces points pour qu'ils fournissent en sortie de la mémoire une information sur leur état; caractérisé en ce qu'il consiste
    – à inhiber la lecture pour certains points-mémoire, pour que ces points se comportent, vus de la sortie, comme des points qui sont dans un état différent du premier état dans lequel ils sont en réalité, et ceci sans sélectionner par ailleurs de points mémoire supplémentaires réservés au test.

14. Procédé selon la revendication 13, caractérisé en ce que la mémoire est du type programmable une seule fois et en ce que les points-mémoire sont tous dans le même état lors du test.

**Patentansprüche**

1. ROM-Speicher mit einem einen Ur- und einem programmierten Zustand aufweisende Netz aus Speicherstellen (Pij), dessen Zustand selektiv und ausgehend von mindestens einen Entcodierer (DL und DC) gelesen werden kann, der befähigt ist, eine Auswahldresse von einer Speicherstelle zu empfangen und befähigt ist, eine Lesespannung (VL) an eine ausgewählte Speicherstelle zu senden, wobei der Speicher einen Testmodusanschluß (T) aufweist, um ein Signal zu empfangen, das angibt, ob der Speicher normal funktionieren oder getest werden soll, dadurch gekennzeichnet, daß er eine durch den Testmodusanschluß gesteuerte Schaltung (10 und 12) umfaßt, um im Testmodus das Unterbinden des Lesens bestimmter Speicherstellen dann zuzulassen, wann die Adresse dieser Stellen durch den Entcodierer empfangen wird, so daß von dem Ausgang des Speichers aus gesehen diese Speicherstellen eine absichtlich falsche Information über deren Urzustand liefern, wobei dieser Vorgang ohne Auswählen mittels dem Entcodierer der zusätzlichen Zeilen oder Spalten stattfindet, die für den Test reserviert sind.

2. Speicher nach Anspruch 1, dadurch gekennzeichnet, daß die Speicherstellen zwei Zustände annehmen können und daß die Information am Ausgang des Speichers in zwei Typen gemäß der Funktion der Speicherstelle vorliegt, so daß:
    – im ersten Zustand durch die adressierte Speicherstelle ein spezifisches elektrisches Signal geliefert wird: und
    – im zweiten Zustand durch die adressierte Speicherstelle kein spezifisches Signal geliefert wird, das anders wäre als die von den nicht adressierten Speicherstellen gelieferten Signale.

3. Speicher nach Anspruch 1, dadurch gekennzeichnet, daß die Speicherstellen Schwebendgate-Transistoren oder ähnliche Elemente sind, die durch eine Lesespannung dann leitend geschaltet werden können, wenn sie nicht durch Programmieren in ihren zweiten Zustand gebracht worden sind, und nicht mehr durch diese Spannung leitend geschaltet werden können, wenn sie durch Programmieren in ihren zweiten Zustand gebracht worden sind.

4. Speicher nach einem der vorhergehenden Ansprüche, dadurch gekennzeichnet, daß er eine Logikschaltung (10, 12, TL1 bis TL4) umfaßt, die befähigt ist, das Anlegen einer Lesepsannung bei einer ausgewählten Speicherstelle zu unterbinden.

5. Speicher nach einem der vorhergehenden Ansprüche, dadurch gekennzeichnet, daß er eine Logikschaltung umfaßt, die befähigt ist, die Weitergabe von Information zwischen einer Spalten leitung und dem Ausgang des speichers zu unterbinden.

6. Speicher nach einem der vorhergehenden Ansprüche, dadurch gekennzeichnet, daß das Unterbinden des Lesens eine Funktion des Zustandes eines Adressbits (A2) einer Zeile ist.

7. Speicher nach einem der vorhergehenden Ansprüche, dadurch gekennzeichnet, daß das Unterbinden des Lesens eine Funktion des Zustandes eines Adressbits (A4) einer ausgewählten Spalte ist.

8. Speicher nach einem der vorhergehenden Ansprüche, dadurch gekennzeichnet, daß er eine Logikschaltung (10, 12, TL1 bis TL4) umfaßt, die befähigt ist, das Lesen des Wertes der Summe eines Zeilenadressbits und eines ausgewählten Spaltenadressbits zu unterbinden, die gleichzeitig mit der Zeile ausgewählt sind, wobei die Zeilenadresse und die Spaltenadresse die Position einer Speicherstelle festlegen, deren Zustand maskiert werden soll.

9. Speicher nach einem der Ansprüche 4 bis 8, bei dem das wertniedrigstete Bit der Zeilenadresse die Auswahl einer der zwei Nebenzeilen ermöglicht und das wertniedrigstete Bit der Spaltenadresse die Auswahl einer der zwei Nebenspalten ermöglicht, dadurch gekennzeichnet, daß er ein Logiktor (10) aufweist, das das wertniedrigstete Bit der Zeilenadresse und das wertniedrigstete Bit der Spaltenadresse empfängt, sowie Schalter (TL1 bis TL4) umfaßt, die befähigt sind, das Lesen dann zu unterbinden, wenn im Testmodus die Summe der wertniedrigsteten Zeilen- und Spaltenbits einen bestimmten Wert hat.

10. Speicher nach Anspruch 4, dadurch gekennzeichnet, daß die Schaltung zum Unterbinden des Anlegens der Lesespannung nicht nur das Anlegen der Spannung bei der ausgewählten Zeile sondern auch gleichzeitig das Anlegen der Lesespannung bei allen anderen Zeilen unterbindet, wenn die dem Entcodierer zugelieferte Adresse der Position einer Speicherstelle entspricht, dessen Zustand maskiert werden soll.

11. Speicher nach Anspruch 5, dadurch gekennzeichnet, daß die Schaltung zum Unterbinden der Weitergabe der Spalten information nicht nur die Weitergabe bezüglich einer ausgewählten Spalte sondern auch gleichzeitig die Weitergabe bei den anderen Spalten unterbindet, wenn die dem Entcodierer zu gelieferte Adresse der Position einer Speicherstelle entspricht, dessen Zustand maskiert werden soll.

12. Speicher nach einem der Ansprüche 1 bis 11, dadurch gekennzeichnet, daß er des nur einmal programmierbaren Typs ist und daß der Zustand der Speicherstellen im Augenblick des Testens bei allen Stellen der gleiche ist.

13. Verfahren zum Testen eines ROM-Speichers, dessen Speicherstellen einen ersten oder einen zweiten Zustand annehmen können, bei dem
– bei einem Entcodierer (DL und DC) nacheinanderfolgende Adressen zu testender Speicherestellen angelegt werden, und
– durch den Entcodierer eine Lesespannung (VL) bei diesen Stellen angelegt wird, so daß am Ausgang des Speichers sie eine Information bezüglich ihres Zustandes liefern, dadurch gekennzeichnet,
– daß man das Lesen bei gewissen Speicherstellen unterbindet, so daß diese Stellen vom Ausgang her betrachtet sich wie Stellen verhalten, die sich in einem anderen Zustand befinden als dem Zustand, dem sie in der wirklichkeit entsprechen, wobei dies ohne die Auswahl zusätzlicher, für das Testen reservierter Speicherstellen stattfindet.

14. Verfahren nach Anspruch 13, dadurch gekennzeichnet, daß der Speicher des nur einmal programmierbaren Typs ist und daß die Speicherstellen im Augenblick des Testens den gleichen Zustand aufweisen.

## Claims

1. A read only memory comprising a network of memory locations (Pij) having an unprogrammed state and a programmed state (Vpp) the state of which may be read selectively by means of at least one decoder (DL, DC) adapted to receive an address for the selection of a memory location and adapted to transmit a read voltage (VL) to a memory location selected, the memory comprising a test mode terminal (T) designed to receive a signal indicating whether the memory should operate normally or be tested, characterized in that it comprises a circuit (10, 12) controlled by the test mode terminal for authorizing, in test mode, inhibition of the reading of certain of the memory locations when the address of these points is received by the decoder in such a manner that, seen from the output of the memory, these memory locations supply intentionally erroneous data concerning their unprogrammed state, this being achieved without also selecting by means of the decoder the additional lines or columns of the memory locations reserved for the test.

2. A memory as claimed in claim 1, characterized in that the memory locations may be in either of two states and in that the information at the output of the memory is of two types depending on the state of the memory location:
– in a first state the memory location addressed supplies a specific electrical signal;
– in a second state the memory location addressed does not supply a specific electrical signal different from the signals issuing from the non-addressed memory locations.

3. A memory as claimed in claim 1, characterized in that the memory locations are floating gate transistors or similar elements which can be made conductive by a read voltage when they are not programmed into their second state and which cannot be made conductive by this voltage when they are programmed into their second state.

4. A memory as claimed in any one of the preceding claims, characterized in that it comprises a logic circuit (10, 12, TL1 to TL4) adapted to inhibit the application of a read voltage on a selected line.

5. A memory as claimed in any one of the preceding claims, characterized in that it comprises a logic circuit adapted to inhibit the transmission of data between a column conductor and the output of the memory.

6. A memory as claimed in any one of the preceding claims, characterized in that the inhibition of reading depends on the state of an address bit (A2) of a line.

7. A memory as claimed in any one of the preceding claims, characterized in that the inhibition of reading depends on the state of an address bit (A4) of a selected column.

8. A memory as claimed in any one of the preceding claims, characterized in that it comprises a logic circuit (10, 12, TL1 to TL4) adapted to inhibit the reading depending on the value of the sum of an address bit of a line and an address bit of a column selected at the same time as the line, the address of the line and the address of the column defining the position of a memory location the state of which it is desired to mask.

9. A memory as claimed in any one of claims 6 to 8 in which the least significant bit of the line address makes it possible to select one of two adjacent lines and the least significant bit of the column address makes it possible to select one of two adjacent columns, characterized in that it comprises a logic gate (10) receiving the least significant bit of the line address and the least significant bit of the column address and switches (T1 to T4) adapted to inhibit reading when, in test mode, the sum of the least significant line and column bits has a specified value.

10. A memory as claimed in claim 4, characterized in that the circuit for inhibiting the application of the read voltage inhibits not only the application of the read voltage to the line selected but also, simultaneously, the application of the read voltage to all the other lines when the address supplied to the decoder corresponds to the position of a memory location the state of which it is desired to mask.

11. A memory as claimed in claim 5, characterized in that the circuit for inhibiting the transmission of data from a column inhibits not only the transmission from a selected column but also, simultaneously, from all the columns when the address supplied to the decoder corresponds to the position of a memory location the state of which it is desired to mask.

12. A memory as claimed in any one of claims 1 to 11, characterized in that it is of the type which is programmable only once and in that the state of the memory locations at the time of test is the same for all the locations.

13. A method for testing a read only memory comprising memory locations which can exist in a first or a second state which consists of
 – applying to a decoder (DL, DC) successive addresses of memory locations to be tested;
– causing the decoder to apply a read voltage (VL) to those locations so that they supply at the output of the memory data concerning their states, characterized in that it consists of
– inhibiting the reading in the case of certain memory locations so that these locations behave, as seen from the output, like locations which are in a different state to the first state, which in reality they are in, this being accomplished without also selecting supplementary memory locations reserved for testing.

14. A method as claimed in claim 13, characterized in that the memory is of the type which is programmable only once and in that the memory locations are all in the same state during the test.

# FIG_1

# FIG_2